# EUROPEAN PATENT SPECIFICATION

(11) **EP 0 742 643 B1**
(45) Date of publication and mention of the grant of the patent: **20.02.2002**
(21) Application number: 96107281.6
(22) Date of filing: 08.05.1996
(51) Int. Cl.: H03H 9/05

(54) **An acoustic surface-wave device and its manufacturing method**
Akustische Oberflächenwellenanordnung und Verfahren zu deren Herstellung
Un dispositif à ondes acoustiques de surface et son procédé de fabrication

(30) Priority: 08.05.1995 JP 10964995
(43) Date of publication of application: 13.11.1996
(73) Proprietor: MATSUSHITA ELECTRIC INDUSTRIAL CO., LTD., Kadoma-shi, Osaka 571-8501 (JP)
(72) Inventor: Onishi, Keiji, Settu-shi, Osaka 566 (JP); Seki, Shun-ichi, Amagasaki-shi, Hyougo 661 (JP); Taguchi, Yutaka, Takatsuki-shi, Osaka 569 (JP); Eda, Kazuo, Nara-shi, Nara 631 (JP)
(74) Representative: Grünecker, Kinkeldey, Stockmair & Schwanhäusser Anwaltssozietät

(56) References cited:
- EP-A- 0 622 897
- DE-A- 4 302 171
- JEE JOURNAL OF ELECTRONIC ENGINEERING, vol. 30, no. 324, 1 December 1993, pages 36-39, XP000422117 KAZUO EDA ET AL: "FLIP-CHIP BONDING TECHNOLOGY FABRICATES GHZ-BAND SAW FILTERS"
- PATENT ABSTRACTS OF JAPAN vol. 95, no. 004 & JP-A-07 111438 (HITACHI LTD), 25 April 1995,

## Description

This invention relates to an acoustic surface-wave device having the features of the preamble of claim 1, and to the manufacturing method of such a device having the features of the preamble of claim 10.

Such a device and such a method is known from DE-A-43 02 171.

Furthermore, EP-A-0 622 897 discloses to protect a comb-electrode by a lid which completely covers a comb-electrode, wherein the lid and the substrate of the comb-electrode are bonded to each other by an inorganic covalent bond, which is formed from the same material as the substrate and the lid, and seals the acoustic surface-wave element in an air-tight condition by the lid.

In accordance to the rapid development of mobile communication systems, the compact, low-height, high performance acoustic surface-wave device, which is one of the key devices constituting communication equipment, is now strongly desired.

Although the wire-bonding method had been widely employed in assembling said acoustic surface-wave device, the miniaturization of acoustic surface-wave devices is limited because of a large wire bonding land area required for this. In addition to this, a short-circuit problem caused by the introduction of conductive foreign objects such as solder particles on the unprotected comb electrode had been produced often. Therefore, a new face-down assembly method such as the method reported in Proceedings on 1993 Japan LEMT Symposium (1993), pp. 109 - 112, had been experimented.

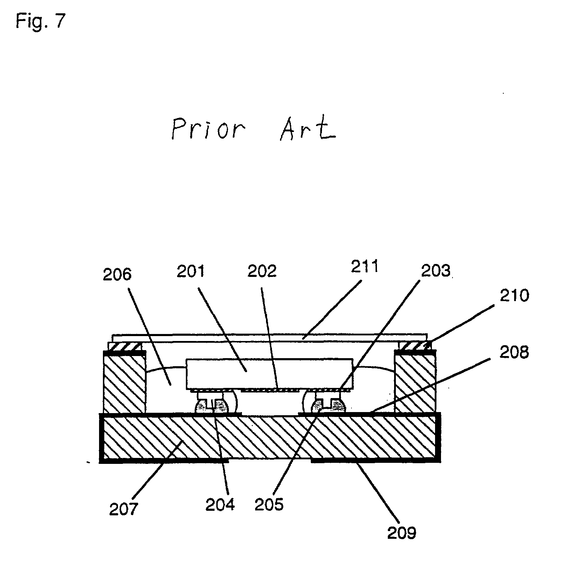

A structure of conventional acoustic surface-wave device assembled by means of said face-down method is now explained by referring to Fig. 7 showing a cross-section of conventional acoustic surface-wave device. In Fig. 7, 201 is a substrate, 202 is comb-electrode, 203 is electrode pad, 204 is conductive bump, 205 is conductive adhesive, 206 is insulating adhesive, 207 is package, 208 is electrode pattern, 209 is external electrode, 210 is sealing, and 211 is a cover.

As shown in the conventional acoustic surface-wave device, conductive bump 204 is disposed first on electrode pad 203 disposed on substrate 201, conductive adhesive 205 is transfer-coated on said conductive bump 204, and device is assembled on electrode pattern 208 disposed on package 207 made of alumina, glass-ceramics, or other materials by means of said face-down method in order to establish an external electrical conduction.

In this structure of the device, since the adhesion strength between substrate 201 and package 207 established only by said conductive bump 204 and conductive adhesive 205 is considered inadequate, it is reinforced by providing insulating adhesive 206.

However, in order to avoid any ill-effects on said surface-wave device, a method applying a high-viscosity insulating adhesive 206 except the peripheral region of said comb-electrode 202 had been employed in order to avoid the blocking of surface-wave propagation at the area around said comb-electrode 202 .

However, although the assembling of said acoustic surface wave device by said face-down method is definitely advantageous for the device miniaturization since no wire bonding lands had to be provided, the exact control of application of insulating adhesive had been left as a difficult problem since there are chances of intrusion of insulating adhesive employed to reinforce the adhesive strength of acoustic surface-wave device into the comb-electrode. That is, since the assembling work of acoustic surface-wave device has to be carried out under a strictly controlled environment protecting the comb-electrode against the intrusion of foreign objects from outside, the practical application of conventional assembling technology had been difficult.

Thus, another conventional face-down bonding method applicable to assemble the acoustic surface wave devices had been reported in Proceedings on 1994 Ultrasonic Symposium (1994), pp. 159 - 162. That means that, without using the reinforcement of insulation adhesive, said conductive bumps and said electrode disposed on the package are directly bonded by means of heat and ultrasonic energy holding said acoustic surface-wave device only by means of conductive bumps. Since this is a method without the use of insulation adhesive, the problems of such including the intrusion of adhesive into said comb-electrode can be solved.

However, another problem such as an ill effect to said acoustic surface-wave device caused by the thermal stress produced by the thermal expansion coefficient difference between said acoustic surface-wave device and the package is possible instead. Therefore, the practical application of these face-down bonding methods having an advantage of compact and low height packaging have been considered very difficult.

### ABSTRACT OF THE INVENTION

The objects of the present invention is to solve these conventional problems, and to offer a compact and low height acoustic surface-wave device, and at the same time, to offer a new manufacturing method thereof.

This object is solved by the acoustic surface-wave device having the features of claim 1, and by the method for manufacturing an acoustic surface- wave device having the features of claim 10. Preferred embodiments are disclosed in the dependent claims.

By taking an embodiment of a thus constructed acoustic surface-wave device and a manufacturing method thereof, the advantages of a compact and a low-height device, easily attained by employing a face-down bonding method, are now explained below.

Since the package is filled with an insulation adhesive while protecting the comb-electrode by means of a protecting means, no viscosity adjustment of insulation adhesive has to be made, so that the coating process can be simplified and the manufacturing method of acoustic surface-wave device can be performed at lower cost. Moreover, since this is an assembling method without the use of heat or ultrasonic energy, there should be no chances harming the characteristics of acoustic surface-wave device.

Moreover, by combining said protective means with said substrate by means of a covalent bonding method, an acoustic surface wave derive of very high reliability without the chances of intrusions of conductive foreign materials, water vapor, or such from outside can be obtained, and moreover, a high frequency module incorporating another high-frequency device or plural acoustic surface-wave devices can be easily obtained.

Since an air-tight sealing can be obtained by said protecting means, the assembly work of acoustic surface-wave device is no longer essential by mounting the acoustic surface device elements on said package means, and since a substantial reduction of the dimension of acoustic surface-wave device is possible also, this may contribute largely to the device miniaturization.

### BRIEF EXPLANATION OF THE DRAWINGS

The several structures of invented acoustic surface-wave devices are now explained below by referring the attached drawings.

Figure 1 shows a cross-section of acoustic surface-wave device of Embodiment-1, showing its schematic structure.

Figure 2 shows a cross-section of the acoustic surface-wave device of Embodiment-1, showing its schematic structure at the peripheral of assembled part.

Figure 3 shows a cross-section of the acoustic surface-wave device of Embodiment-2, showing its schematic structure at the peripheral of assembled part.

Figure 4 shows a cross-section of the acoustic surface-wave device of Embodiment-3, showing its schematic structure at the peripheral of assembled part.

Figure 5 shows a cross-section of the acoustic surface-wave device of Embodiment-4, showing its schematic structure at the peripheral of assembled part.

Figure 6 shows a cross-section of the acoustic surface-wave device of Embodiment-5, showing its schematic structure at the peripheral of assembled part.

Figure 7 shows a cross-section of the contentional acoustic surface-wave device, showing its schematic structure.

### DETAILED EXPLANATION OF THE INVENTION

The structures of the invented acoustic surface-wave devices are now explained below by referring the attached drawings.

### EMBODIMENT-1

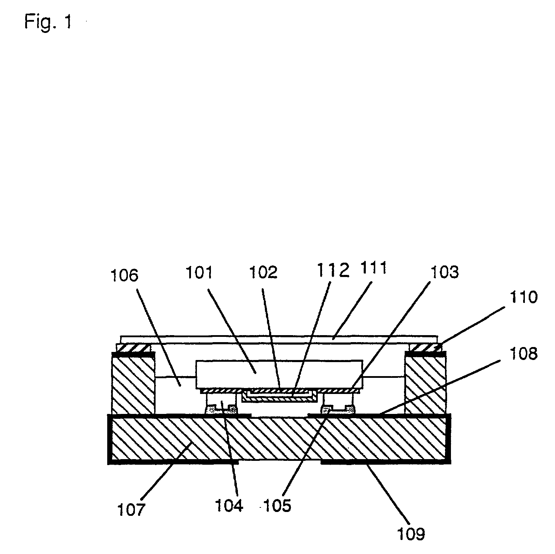

Figure 1 shows a cross-section of acoustic surface-wave device of Embodiment-1, showing its schematic structure. In Fig. 1, 101 is a substrate, 102 is a comb-electrode, 103 is electrode pads, 104 is conductive bumps, 105 is conductive adhesive, 106 is insulating adhesive, 107 is a package, 108 is electrode pattern, 109 is an external electrode, 110 is sealing, 111 is a cover, and 112 is a protective means.

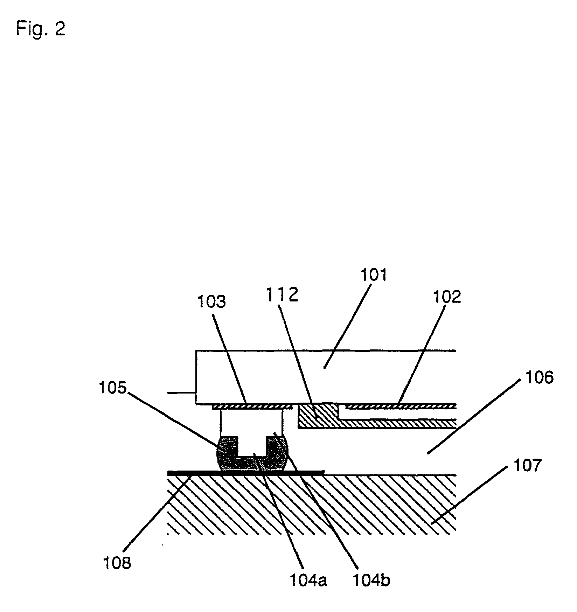

Figure 2 shows a cross-section of the acoustic surface-wave device of Embodiment-1, showing its schematic structure at the peripheral of assembled part.

In Fig. 2, 101 is a substrate, 102 is a comb-electrode, 103 is electrode pads, 104a is a top of said conductive bump, 104b is a base of said conductive bump, 105 is conductive adhesive, 106 is insulating adhesive, 107 is a package, 108 is an electrode pattern, 112 is a protective means, 112 is a protective means, and 113 is a direct bonding part.

In Embodiment-1, a 36° Y-cut X-propagation lithium tantalate crystal is used as substrate 101, comb-electrode 102 and electrode pad are made of metal thinfilm made mainly of gold patterned by using a conventional photolithographic method combined with a lift-off method. However, the substrate material to which the embodiments of the invention are applicable is not limited to the lithium tantalate crystal but is applicable to other crystals such as lithium niobate, quartz, lithium borate .

Embodiment-1 is characterized by direct bonding of protecting means 112 protecting said comb-electrode of acoustic surface wave device onto substrate 101. In here, said direct bonding means covalent bonding performed at a substantially atomic level in bonding two different substrates together.

The reason for employing the direct bonding for Embodiment-2 is to obtain a high degree air-tightness at the peripheral of comb-electrode since the characteristics of acoustic surface wave device is influenced much by the condition of comb electrode. For example, the characteristics of acoustic surface-wave device is deteriorated easily by the moisture adsorbed in said comb electrode at the process of substrate dicing performed at the poor air-tightness. Moreover, if the air-tightness is not maintained properly allowing the intrusion of moisture after the device assembling, the device reliability would be lost because of the slow deterioration of device characteristics.

Therefore, the introduction of direct bonding technology enabling the bonding two components at an atomic level, is essential in these embodiments, and by using this device, a highly reliable acoustic surface-wave device would be realized.

Although the direct bonding is a bonding technology applicable for the bonding of two different substrates, a square single-crystal substrate having a cut angle same as that of substrate 101 is employed as the material of protection means 112 in here in order to establish a crystallographic consistency with substrate 101.

This is because that the characteristics of acoustic surface wave device may well be influenced by the lattice distortion caused by the difference of lattice constants or residual stress caused by the different thermal expansion coefficients, since the direct bonding of substrates is performed at an atomic level. Furthermore, this is because that substrate 101 and protection means 112 shall desirably be of same materials since the adequate bonding strength could not be obtained otherwise.

The invented manufacturing method of acoustic surface-device is now explained below. An indentation having a depth of about 10 µm is formed on an area of protection means 112 facing to comb-electrode 102 disposed on substrate 101 by using a fluoro-nitric acid system etchant providing a specific space to comb-electrode 102, ensuring free-propagation of acoustic surface-wave.

Although only an example where said indentation is formed by a fluoro-nitric acid system etchant is shown here, a mechanical method such as sand-blasting may also be used to form said indentation. The depth of said indentation may be less than 10 µm considering the thickness of comb-electrode 102 so far as the propagation of acoustic surface-wave is not disturbed. The wall thickness of protection means 112, that is, bonding width 103 can be an order of 250 µm.

Then, direct bonding of said substrate 101 onto said protection means 112 is performed. After mirror-finishing the bonding face first, substrate 101 and protection means 112 are washed, and a hydrophilic processing using a mixed liquid of aqueous hydrogen peroxide and aqueous ammonia is applied thereon.

Then, substrate 101 and protection means 112 are aligned and pressed together. By this, bonding bounded by water molecules is established. Finally, the direct bonding process establishing a covalent bonding between substrate 101 and protection means 112 is ended by applying a heat treatment of about 200°C expelling the water molecules remaining on the boundary.

Then, conductive bumps 104 are deposited on electrode pads 103 disposed on said substrate by using a ball-bonding method employing gold wire. In this bump forming process, the employment of wet-process such as an electro-plating is undesirable since acoustic surface-wave device 101 is a device sensitive to water molecules, and the employment of dry-process using gold bumps is desirable instead.

At the final process, conductive bumps 104 are pressed on the mirror-finished base at a load of about 50 grams per bump in order to obtain plural conducting bumps having uniformly leveled tops.

Fig. 2 shows a cross-section of said direct bonding, showing a peripheral structure thereof. As shown in Fig. 2, the obtained conductive bump 104 has a double-protrusion structure consisting of top 104a and base 104b. Then, top 104a of said conductive bump is immersed into a layer of phenoxy-system thermo-plastic conductive adhesive in which silver-paradium alloy particles are dispersed, coated on a base of the bump in order to transfer said conductive adhesive layer 105 on top 104a of said bump 104.

Then, said substrate 101 is bonded face-down on electrode pattern 108 disposed on an alumina package by means of said conductive adhesive layer 105. Since the embodiment shown in Fig. 2 is a bonding method without the application of heat or ultrasonic energy as shown in Proceedings on 1994 Ultrasonic Symposium, pp. 159 - 162, there should be no problem of adverse effect of thermal stress or such on the characteristics of acoustic surface-wave device.

According to this embodiment of the invention, the height of base 104b of the conductive bump has to be set at a height slightly higher than the height of protective means 112 in order to allow the transfer of conductive adhesive layer 105 on top 104a of the conductive bump.

In this embodiment, the height of base 104b of said conductive bump is 50 µm and the thickness of said protecting means 112 is 40 µm. These are to avoid the chance of adhesion of conductive resin 105 on said protecting means 112, and this is possible if the height of protecting means 112 is lower than the height of base 104b.

Moreover, although the silver-paradium alloy particle is used as a conductive filler of the conductive adhesive in this embodiment, metal filler particles of other type may be used. In addition to this, although phenoxy-system thermo-plastic conductive adhesive is used as a binder of said conductive adhesive in here, a silicon or epoxy resin system thermo-setting adhesive can be used as well.

Since an adequate mechanical strength holding substrate 101 can not be obtained by means of conductive bump 104 and conductive adhesive 105 only, insulating resin 106 is filled completely in said space provided between said protecting means which is directly bonded on said substrate 101 and said package 107 in order to reinforce the adhesion strength by utilizing the shrinkage stress at hardening. Though a silicon system thermo-setting adhesive is used as insulating resin 106 in this embodiment, needless to day that the same effect can also be obtained by using an epoxy system thermo-setting adhesive.

In this embodiment of the invention, since a space is provided on the comb-electrode of substrate 101 by means of said indentation of protecting means 112, this can be filled completely with low-viscosity insulating adhesive without the adjustment of its viscosity. Since the productivity can be improved and the introduction of foreign material during the assembly process can be prevented, not only the higher production yield but the lower production cost can be obtained.

As above-explained, the invented acoustic surface-wave device is constituted of a comb-electrode formed on the main surface of said substrate, plural electrode pads disposed on the peripheral of said comb-electrode, a protection means covering said comb-electrode through a space formed by the substantially covalent bonding established between said comb-electrode and said plural electrode pads, conductive bumps formed the top of said plural electrode pads, conductive adhesive disposed at least on top of said conductive bumps, a package adhered on said conductive bumps by means of said conductive adhesive, and insulating adhesive contacting with said conductive adhesive, said conductive bumps, and said protection means filling said package.

By this, the practical employment of face-down system assembly method is realized obtaining a compact and low-height acoustic surface-wave device easily.

This means, while the viscosity adjustment of insulating resin and its coating process had been difficult in manufacturing the acoustic surface-wave device by the conventional method, with the invented method using said protection means filled completely with low viscosity insulating resin, the production yield can be substantially improved and the production cost can be considerably reduced. Furthermore, by providing said protection means, the chance of introduction of foreign materials into comb-electrode part during the assembly process can be complelety elliminated.

Moreover, as shown in this embodiment, the effect of thermal stress caused by a difference in the thermal expansion coefficients between the substrate and the protection means can be eliminated by employing a single-crystal substrate having a cut same as that of the substrate, so that the acoustic surface-wave device of excellent frequency characteristics can be obtained.

### Embodiment-2

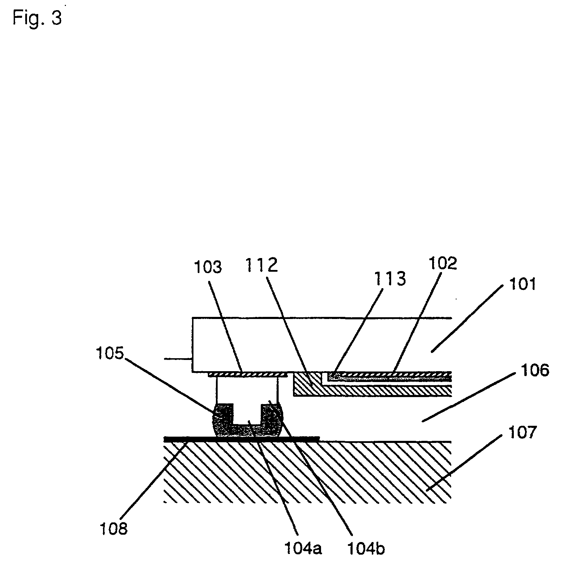

Fig. 3 shows a cross-section of the invented acoustic surface-wave device of Embodiment-2, and showing particularly a schematic structure of the device assembled on said substrate. In Fig. 3, 101 is a substrate, 102 is a comb-electrode, 103 is electrode pads, 104a is the top of conductive bump, 104b is the base of said conductive bump, 105 is conductive adhesive, 106 is insulating adhesive, 107 is a package, 108 is an electrode pattern, 112 is a protection means, 113 is a direct bonding part, and 113 is an insulating protection layer.

Like the case of Embodiment-1, a 36° Y-cut X-propagation lithium tantalate crystal is used as substrate 101 and protection means 112 also. However, similar effect can be obtained by using a single crystal substrate of lithium niobate, quartz crystal, lithium borate, or such. On the other hand, comb-electrode 102 and electrode pads 103 of aluminum alloy thinfilm are formed by using a conventional photolithographic method. Then, metal thinfilm as a protection layer is deposited on the peripheral of comb-electrode 102 over said wiring pattern excluding electrode pads 103 and comb-electrode 102. Moreover, a silicon oxide layer acting as an insulating protection layer is deposited for a thickness of about 8000 Å by using a sputtering method. As a material of insulating protection layer 113, silicon may be used instead of silicon oxide.

Like the case of Embodiment-1, an indentation is provided on protection means 112 at an area facing to comb-electrode 102 disposed on substrate 101 by using a fluoro-nitric acid system etchant. The direct bonding of substrate 101 onto protection means 112 is performed by using the method shown in Embodiment-1.

When a comb-electrode made of aluminum alloy thinfilm is used like the case of Embodiment-2, the surface of comb-electrode 102 is corroded in said hydrophilic processing for direct bonding. However, the corrosion of comb-electrode 102 can be prevented by depositing insulating protection layer 113 around comb-electrode 102, so that said direct bonding process can be performed even in a case where comb-electrode is made of aluminum alloy.

Then, conductive bumps 104 are disposed on electrode pads 103 formed on substrate 101 by a method of ball-bonding using gold wire, and conductive adhesive 105 is transfer-coated on said conductive bumps 104 after leveling the height of these. After this, substrate 101 is face-down bonded thereon by using conductive adhesive 105. Since the bonding strength realized by using conductive bump 104 and conductive adhesive 105 only is inadequate to hold down substrate 101, insulating resin 106 is filled in the space between package 107 and protecting means 112 bonded directly on substrate 101 in order to supplement the adhesion strength by using the stress of insulating resin 106 at hardening.

In this process, since comb-electrode 102 disposed on substrate 101 is protected by the space secured by the indentation of protecting means 112, said filling can be made without the viscosity adjustment of insulating resin like the case of conventional face-down bonding, and said space is filled completely by the low-viscosity insulating adhesive, the device productively can be improved considerably. Furthermore, since comb-electrode 102 is covered by insulating protection layer 113, it can be bonded directly onto said protecting means even when it is made of metal thinfilm such as aluminum alloy which is erroded easily, so that the introduction of conductive foreign objects in the assembling process can be prevented and the production yield of the device can be improved.

As above-described, the acoustic surface-wave device of Embodiment-2 consists of a substrate, comb-electrode disposed on the main surface of said substrate, plural electrode pads disposed on the peripheral of said comb-electrode, insulating protection layer disposed on said comb-electrode, protecting means covering said comb-electrode enclosing a space produced by a substantially covalent bonding established between said substrate, said comb-electrode and said plural electrode pads, conductive bumps disposed on said plural electrode pads, conductive adhesive disposed at least on the top of said conductive bumps, a package adhered on said conductive bumps by means of said conductive adhesive, and insulating adhesive filled to contact with said conductive bumps, said protecting means, and said package. By this, the face-down system bonding can be applied even when the comb-electrode made of an aluminum alloy which is easily corroded is employed obtaining a compact and low profile acoustic surface-wave device easily.

This means that the viscosity adjustment and coating of insulating resin which had been difficult in the conventional process assembling the acoustic surface-wave device is eliminated, and low viscosity insulating resin is filled in the space provided below the protecting means so that the production yield can be higher while the production cost can be lowered. By providing the protecting means, introduction of conductive foreign objects during the assembling process can be prevented.

Like the case of Embodiment-2, by using a protecting means made of a single crystal substrate having a cut angle same as that of the substrate, the thermal stress due to the difference in the thermal expansion coefficients between the substrate and the protecting means can be eliminated so that the acoustic surface-wave device of excellent frequency characteristics can be obtained.

### Embodiment-3

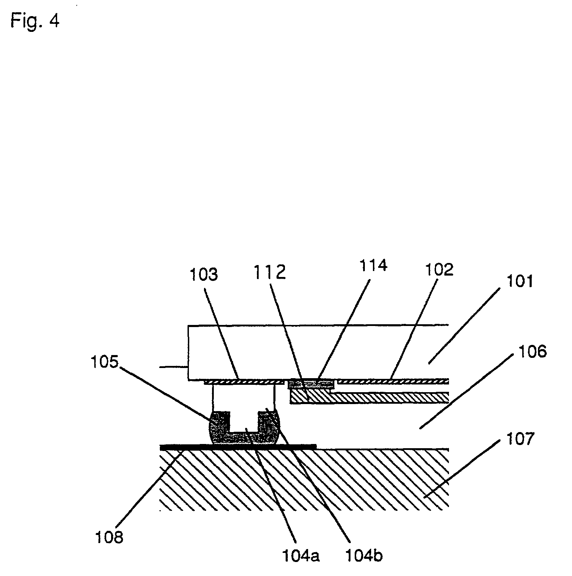

Fig. 4 shows a cross-section of the invented acoustic surface-wave device of Embodiment-3, and showing particularly a schematic structure of the device assembled on said substrate. In Fig. 4, 101 is a substrate, 102 is a comb-electrode, 103 is electrode pads, 104a is a top of conductive bump, 104b is a base of said conductive bump, 105 is conductive adhesive, 106 is insulating adhesive, 107 is a package, 108 is an electrode pattern, 112 is a protecting means, and 113 is a direct bonding part. and 114 is an insulation layer.

In Embodiment-3, like the case of Embodiment-1, 36° Y-cut X-propagation lithium tantalate crystals are used both as substrate 101 and protection means 112. However, similar effects can be obtained by employing a single crystal substrate of lithium niobate, quartz crystal, lithium borate, or such. On the other hand, comb-electrode 102 and electrode pads 103 of metal thinfilm made mainly of gold are formed by using a conventional photolithographic (lift-off) method. Furthermore, a silicon oxide layer as an insulation layer 114 is deposited for a thickness of about 2 µm on the area of direct bonding by a sputtering method. As a material of insulation layer 114, silicon can be used instead of silicon oxide. In here, the thickness of insulation layer 114 is made much thicker than that of comb-electrode 102 so that the step of wiring electrode is adequately covered.

By employing an adequately thick insulation layer 114, the stress effected on the substrate can be relieved. That is, the stress produced at the direct bonding can be relieved so that the negative effect of stress on the characteristics of acoustic surface-wave device can be eliminated.

In order to undisturb the propagation of surface-wave, an indentation is provided on protecting means 112 on a part facing to comb-electrode 102 of substrate 101 by using fluoro-nitric acid system etchant. In here, the direct bonding of substrate 101 onto protecting means 112 is performed by the method shown in Embodiment-1.

The direct bonding in Embodiment-3 is conducted at the boundary between the 36° Y-cut X-propagation lithium tantalate crystal constituting the protecting means and the silicon oxide layer constituting the insulation layer. Since the direct bonding is fundamentally a technology applicable to the bonding of different materials, an excellent bonding can be obtained in this case where the components of same materials are bonded like the case of Embodiment-1.

Although not shown in the drawing, there should be region where a wiring pattern exists between the comb-electrode 102 of acoustic surface-wave device and the electrode pad 103. In this case, therefore, there should be a step or a gap between the wiring part and none-wiring part so that no perfect hermetic seal equivalent to direct bonding can not be obtained. Therefore, when this step can be a problem, said protecting means is directly bonded after insulating layer 114 is leveled out by applying a chemical and mechanical polishing, securing a hermetic sealing of higher degree. In this case, the conventional package would be not be required, producing an extra effect of more compact acoustic surface-wave device realized at a lower cost.

In Embodiment-3, though a single crystal substrate same as said substrate on which acoustic surface-wave device is constituted is utilized as the protecting means, a glass substrate having a thermal expansion coefficient same at that of said substrate on which said acoustic surface-wave device is disposed and enabling the direct bonding to said insulation layer can be used. Moreover, a quartz crystal substrate bondable easily to said insulation layer made of silicon oxide may be used.

Then, conductive bumps 104 are formed on electrode pad 103 disposed on substrate 101 by a ball-bonding method using gold wire, and conductive adhesive 105 is transfer-coated on said conductive bumps 104 after leveling the height of the bumps. After this, substrate 101 is face-down bonded by using conductive adhesive 105. Since the bonding strength realized by using only conductive bump 104 and conductive adhesive 105 is not adequate to hold down substrate 101, insulating resin 106 is filled in the space provided between package 107 and holding substrate 112 bonded directly on substrate 101 in order to fortify the adhesive strength by utilizing the stress of insulating resin 106 at hardening.

In Embodiment-3, since comb-electrode 102 disposed on substrate 101 is provided with an indentation formed on protecting means 112, the conventionally needed viscosity adjustment of insulating adhesive is not necessary, and the space is filled completely with the low-viscosity insulating adhesive.

As above described, the acoustic surface-wave derive of the invention consists of a substrate, a comb-electrode disposed on the main surface of said substrate, plural electrode pads disposed on the peripheral of said comb-electrode, insulating protection layer disposed on said comb-electrode surrounding said comb-electrode between said comb-electrode and said plural electrode pads, protecting means covering said comb-electrode enclosing a space produced by performing substantially covalent bonding of said substrate to said comb-electrode and said plural electrode pads, conductive bumps disposed on said plural electrode pads, conductive adhesive disposed at least on the top of said conductive bumps, package adhered on said conductive bumps by said conductive adhesive, and insulating adhesive filled to contact with said conductive bumps, said protecting means, and said package. By this, the face-down system bonding can be applied even when the comb-electrode made of easily corroded aluminum alloy is employed obtaining compact and low profile acoustic surface-wave device can be obtained easily.

That is, with the conventional process assembling the acoustic surface-wave device, the viscosity adjustment and the coating processes of insulating resin had been difficult, and those can be eliminated by using a low viscosity insulating resin filling the space provided under the protecting means so that a higher production yield while a lower production cost can be obtained. By providing the protecting means, introduction of conductive foreign material during the assembling process can be complelety prevented.

Since the thermal stress due to the difference in the thermal expansion coefficients between the substrate and the protecting means can be absorbed in this embodiment, the acoustic surface-wave device of excellent frequency characteristics can be obtained also.

Moreover, the conventionally needed package can be eliminated since the sealing of comb-electrode is realized by said protecting means and by leveling said insulation layer.

### Embodiment-4

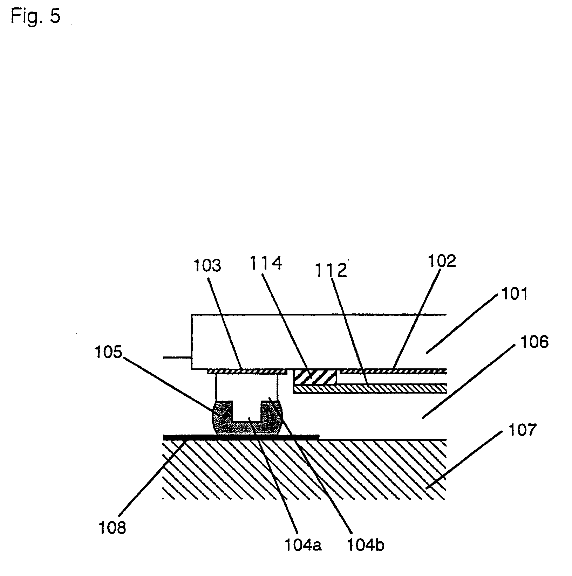

Fig. 5 shows a schematic cross-section of the invented acoustic surface-wave device of Embodiment-4, and showing particularly a schematic structure of the device assembled on said substrate. In Fig. 5, 101 is a substrate, 102 is a comb electrode, 103 is electrode pads, 104a is a top of conductive bump, 104b is a base of said conductive bump, 105 is conductive adhesive, 106 is insulating adhesive, 107 is a package, 108 is an electrode pattern, 112 is a protecting means, and 113 is a direct bonding part. and 114 is an insulation layer.

In Embodiment-4, like the case of Embodiment-1, 36° Y-cut X-propagation lithium tantalate crystals are used as substrate 101 and protection means 112. However, same effects could be obtained by employing a single crystal substrate of lithium niobate, quartz, lithium borate, or such. On the other hand, comb electrode 102 and electrode pads 103 made of metal thinfilm made mainly of gold are formed by using a conventional photolithographic (lift-off) method. Furthermore, a pattern of silicon oxide layer acting as an insulation layer surrounding comb-electrode is deposited on substrate 101 and this is acting as a spacer in order to indisturb the propagation of surface-wave.

In here, said insulation layer is deposited for a thickness of about 2 µm which is considerably thicker than the thickness of comb-electrode. Though a sputtering method is used to deposit said silicon oxide pattern here, a coated type insulation layer may be used because of its excessive sputtering period. The direct bonding between substrate 101 and protecting means 112 on which insulation layer 114 is deposited is performed by the method described in Embodiment-3. Since the direct bonding in Embodiment-4 is performed at the boundary between the 36° Y-cut X-propagation lithium tantalate crystal and the insulation layer deposited on said protecting means, excellent bonding can be obtained like the case of Embodiment-1.

Although a single crystal substrate identical with the substrate on which the acoustic surface-wave device is constructed is used as a protecting means, a glass substrate having a thermal expansion coefficient same as that of acoustic surface-wave device and a high bondability to said insulation layer may be used as well. Moreover, a quartz crystal substrate having a thermal expansion coefficient same as that of said insulation layer made of silicon oxide may also be used.

In Embodiment-4, a flat plate type protecting means 112 is used since a space against said comb-electrode is automatically provided by means of insulation layer 114 and no indentation has to be provided on protecting means 112, the production cost can be reduced further.

Then in next, conductive bumps 104 are formed on electrode pad 103 disposed on substrate 101 by a ball-bonding method using gold wire, and conductive adhesive 105 is transfer-coated on said conductive bumps 104 after leveling the heights of bumps. After this, substrate 101 is face-down bonded by using conductive adhesive 105. Since the bonding strength obtained by conductive bump 104 and conductive adhesive 105 only is not adequate to hold down substrate 101, insulating resin 106 is filled in the space provided between package 107 and substrate 101 in order to fortify the adhesive strength by utilizing the shrinkage stress of insulation resin 106 at hardening.

In Embodiment-4, since comb-electrode 102 disposed on substrate 101 is provided with an indentation formed on protecting means 112, the conventionally needed viscosity adjustment of insulation adhesive is not necessary, and the space is filled completely with the low-viscosity insulation adhesive.

As above described, the acoustic surface-wave derive of the invention consists of a substrate, a comb-electrode disposed on the main surface of said substrate, plural electrode pads disposed on the peripheral of said comb-electrode, an insulation layer disposed on said comb-electrode surrounding said comb-electrode between said comb-electrode and said plural electrode pads, a protecting means covering said comb-electrode enclosing a space produced by performing a substantially covalent bonding of said substrate to said comb-electrode and said plural electrode pads, conductive bumps disposed on said plural electrode pads, conductive adhesive disposed at least on the top of said conductive bumps, a package adhered on said conductive bumps by means of said conductive adhesive, and an insulation adhesive filled to contact with said conductive bumps, said protecting means, and said package. By this, a face-down system bonding is applied here attaining a compact and low profile acoustic surface-wave device easily.

That is, with the conventional process assembling the acoustic surface-wave device, the viscosity adjustment and the coating processes of insulating resin had been difficult. Those can be eliminated by using a low viscosity insulating resin filling the space provided under the protecting means. Therefore, the production yield can be higher while the production cost can be lower. By providing said protecting means, introduction of conductive foreign objects during the assembling process can be prevented completely.

Since said flat-plate shaped protecting means is realized by depositing a thick insulating means, so that the process to provide an indentation can be eliminated, reducing further the production cost and expanding the range of choice of substrate materials.

Moreover, like the present embodiment of the invention, by providing a thick insulation layer, the thermal stress due to the difference in the thermal expansion coefficients between the substrate and the protecting means can be absorbed in this embodiment, an acoustic surface-wave device of excellent frequency characteristics can be obtained.

Moreover, by disposing a thick insulating means at the direct bonding part of substrate and by leveling said insulating means, the better sealing of said comb-electrode can be obtained by said protecting means only. In this case, the conventionally needed package can be eliminated, realizing a more compact acoustic surface-wave device at a still lower cost.

### Embodiment-5

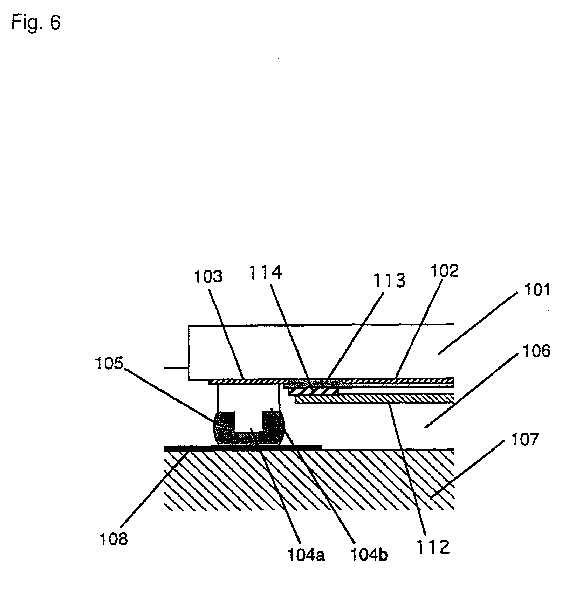

Fig. 6 shows a schematic cross-section of the invented acoustic surface-wave device of Embodiment-5, and showing particularly a schematic structure of the device assembled on said substrate. In Fig. 6, 101 is a substrate, 102 is a comb-electrode, 103 is electrode pads, 104a is a top of conductive bump, 104b is a base of said conductive bump, 105 is a conductive adhesive, 106 is an insulating adhesive, 107 is a package, 108 is an electrode pattern, 112 is a protecting means, 113 is a direct bonding part, 113 is an insulating protection means, and 114 is an insulation layer.

In Embodiment-5, 41° Y-cut X-propagation lithium niobate crystals are used as substrate 101 and protection means 112. On the other hand, comb electrode 102 and electrode pads 103 made of metal thinfilm made mainly of an alunimum alloy are formed by using a conventional photolithographic method. Furthermore, insulating protection layer 113 is formed on an area where no metal thinfilm acting as a protecting layer is formed on the electrode region made of aluminum alloy, that is, surrounding the direct bonding area and comb-electrode 102. By this, the possible corrosion of comb-electrode 102 during said direct bonding process is prevented, so that the application of direct bonding process is possible even when a comb-electrode made of aluminum alloy is used.

An air-tight sealing can be obtained when said protecting means is bonded directly onto insulation layer 114 after its leveled out by applying a mechanical polishing. Moreover, a pattern of silicon oxide insulation layer acting as a spacer surrounding said comb-electrode 102 is disposed on a part of substrate 101 facing to comb-electrode 102 in order to undisturb the propagation of acoustic surface-wave.

In here forming said silicon oxide layer, like Embodiment-4, a sputtering method is used. The direct bonding of substrate 101 and protecting means 112 on which insulation layer 114 is disposed is performed by a method described in Embodiment-3. Though the direct bonding shown in Embodiment-5 is performed at a boundary between the insulation protecting layer formed on a 41° Y-cut X-propagation lithium niobate crystal acting as a substrate and the insulation layer formed on said protecting means, excellent bonding like the one obtained with Embodiment-1 can be obtained.

Though In Embodiment-5, a single crystal substrate identical with the substrate on which the acoustic surface-wave device is constructed is used as a protecting means, a glass substrate having a thermal expansion coefficient same as that of acoustic surface-wave device substrate and high bondability to said insulation layer may be used as well. Moreover, a quartz crystal substrate having a thermal expansion coefficient same as that of said insulation layer made of silicon oxide may be used also.

Then in next, conductive bumps 104 are formed on electrode pad 103 disposed on substrate 101 by a ball-bonding method using gold wire, and conductive adhesive 105 is transfer-coated on said conductive bumps 104 after leveling the heights of bumps. After this, substrate 101 is face-down bonded by using conductive adhesive 105. Since the bonding strength attainable by conductive bump 104 and conductive adhesive 105 only is not adequate to hold down substrate 101, insulating resin 106 is filled in the space provided between package 107 and substrate 101 in order to incease the adhesive strength by utilizing the shrinkage stress of insulating resin 106 at hardening.

In Embodiment-4, since comb-electrode 102 disposed on substrate 101 is provided with said indentation formed on protecting means 112, the conventionally needed viscosity adjustment of insulating adhesive is unnecessary, and the space can be filled completely with the low-viscosity insulating adhesive.

As above described, the acoustic surface-wave derive of the invention consists of a substrate, a comb-electrode disposed on the main surface of said substrate, plural electrode pads disposed on the peripheral of said comb-electrode, insulating protection layer disposed on said comb-electrode, an insulation layer disposed surrounding said comb-electrode between said comb-electrode and said plural electrode pads, a flat protecting means covering said comb-electrode through a space produced by performing a substantially covalent bonding of said substrate to said insulating means, conductive bumps disposed on said plural electrode pads, conductive adhesive disposed at least on the top of said conductive bumps, package adhered on said conductive bumps by means of said conductive adhesive, and an insulating adhesive filled to contact with said conductive bumps, said protecting means, and said package. By this, said face-down system bonding is applied attaining a compact and low profile acoustic surface-wave device easily.

That means that, with the conventional process assembling the acoustic surface-wave device, the viscosity adjustment and the coating processes of insulating resin which were left as difficult problems, those can be eliminated completely by using a low viscosity insulating resin filling the space provided under the protecting means so that a higher production yield while a lower production cost can be obtained. By providing said protecting means, introduction of conductive foreign particles during the assembling process can be prevented.

Moreover, since a flat plate-shaped protecting means can be realized by depositing a thick insulating means, the process to provide an indentation on said protecting means can be eliminated reducing further the production cost and expanding the range of choice of substrate materials.

In addition to these, like the present embodiment of the invention, by providing a thick insulation layer, the thermal stress produced by the difference in the thermal expansion coefficients between the substrate and the protecting means can be absorbed in here, so that an acoustic surface-wave device of excellent frequency characteristics can be produced.

Furthermore, by depositing an insulation layer on the direct bonding region of substrate and leveling said insulation layer, a high degree sealing of comb-electrode can be obtained by said protecting means only. In this case, the conventionally needed package becomes unnecessary attaining a more compact and lower cost acoustic surface-wave device.

## Claims

1. An acoustic surface-wave device comprising:
a substrate (101);
a comb-electrode (102) formed on a main surface of said substrate (101);
plural electrode pads (103) disposed on the periphery of said comb-electrode (102);
a protection means (112);
conductive bumps (104) formed on the tops of said plural electrode pads (103);
a conductive adhesive layer (105) disposed at least on the tops of said conductive bumps (104);
a package (107) adhered on said conductive bumps (105) by means of said conductive adhesive (105); and
insulating adhesive (106) filling the space between said package (107) and said substrate (101), such that the insulating adhesive (106) is in contact with said conductive adhesive (105), said conductive bumps (104), and said protection means (112);
**characterized in that**
said protection means (112) covers said comb-electrode (102) **in that** there is a gap between said protection means (112) and said comb-electrode (102), wherein said protection means (112) is bonded to said substrate (102) or to an insulating layer (114) provided between said substrate and said protection means (112), by a substantially covalent bonding, in a region between said comb-electrode (112) and said plural electrode pads (103), and **in that**
the height of a base of each conductive bump is higher than the height of the protective mans, where each conductive bump has a double protrusion structure consisting of a top and a base.

2. An acoustic surface-wave device according to claim 1, wherein an indentation is provided in said protecting means (112) at a region facing to said comb-electrode region (102).

3. An acoustic surface-wave device according to claim 1, wherein said protecting means (112) consists of a single crystal made of the same material as that of said substrate (101) and/or made with the same cut-angle as said substrate.

4. An acoustic surface-wave device according to claim 1, wherein an insulating protection layer (113) is formed on said comb-electrode (102).

5. An acoustic surface-wave device according to claim 4, wherein an insulating protection layer (113) consists of an inorganic material of either silicon or silicon oxide.

6. An acoustic surface-wave device according to claim 1, wherein said conductive bump (104) consists of a base (104b) bonded to said electrode pad (103) and a protrusion (104a) formed on said base (104b), wherein the height of said base (104b) is higher than the height of said protecting means (112).

7. An acoustic surface-wave device according to any of the preceding claims, wherein said insulating layer (114) is formed to surround said comb-electrode (102) at a region between said comb-electrode (102) and said plural electrode pads (103).

8. An acoustic surface-wave device according to claim 7, wherein said insulation layer (114) is made of an inorganic material of either silicon or silicon oxide.

9. An acoustic surface-wave device according to claim 7, wherein said protection means (112) is made of either quartz or glass.

10. A manufacturing method of an acoustic surface-wave device comprising:
a process to form a comb-electrode (102) on a substrate (101);
a process to form plural electrode pads (103) on said substrate (101);
a process of providing a protecting means (112), forming a closed space between said comb-electrode (102) and said protecting means (112);
a process to form conductive bumps (104) on said plural electrode pads (103);
a process to form conductive adhesive layer (105) at least on the tops of said conductive bumps (104);
a process to adhere said conductive bumps (104) on to an electrode pattern (108) disposed on a package (107); and
a process to fill the space between said package (107) and said substrate (101) with an insulating adhesive (106) such that said insulating adhesive (106) is in contact with said conductive bumps (104), said conductive adhesive (105) and said protecting means (112);
**characterized in that**
said protecting means (112) is bonded to said substrate (102) or to an insulating layer (114) provided between said substrate (102) and said protecting means (112) by a substantially covalent bonding, in a region between said comb-electrode (102) and said plural electrode pads (103); and **in that**
the height of a base of each conductive bump is higher than the height of the protective mans, where each conductive bump has a double protrusion structure consisting of a top and a base,

11. A manufacturing method of acoustic surface-wave device according to claim 10, including a process to form an insulation layer (114) surrounding said comb-electrode (102) at the region between said comb-electrode (102) and said plural electrode pads (103).

12. A manufacturing method of acoustic surface-wave device according to claim 11,
**characterized by**
a process to level the surface of said insulation layer (114).

13. A manufacturing process of surface-wave device according to any of claims 10 to 12, including a process to form an insulating protection layer (113) on said comb-electrode (102).

## Patentansprüche

1. Akustische Oberfiächenweiien-Vorrichtung, enthaltend:
ein Substrat (101);
eine Kammelektrode (102), die auf einer Hauptoberfläche des Substrates (101) ausgebildet ist;
mehrere Elektrodenflächen (103), die sich am Rand der Kammelektrode (102) befinden;
eine Schutzeinrichtung (112);
Leitungsanschlüsse (104), die auf den Oberseiten der zahlreichen Elektrodenflächen (103) ausgebildet sind;
eine leitfähige Haftschicht (105), die sich wenigstens auf den Oberseiten der Leitungsanschlüsse (104) befindet;
eine Packung (107), die auf den Leitungsanschlüssen (105) mit Hilfe der leitfähigen Haftschicht (105) haftet, und
ein isolierendes Haftmittel (106), das den Zwischenraum zwischen der Packung (107) und dem Substrat (101) derart ausfüllt, daß dieses isolierende Haftmittel (106) in Kontakt mit der leitfähigen Haftschicht (105), den Leitungsanschlüssen (104) und der Schutzeinrichtung (112) steht;
**dadurch gekennzeichnet, daß**
die Schutzeinrichtung (112) die Kammelektrode (102) bedeckt und es einen Zwischenraum zwischen der Schutzeinrichtung (112) und der Kammelektrode (102) gibt, wobei die Schutzeinrichtung (112) an das Substrat (102) oder an eine Isolierschicht (114), die zwischen dem Substrat und der Schutzeinrichtung (112) ausgebildet ist, in einem Bereich zwischen der Kammelektrode (102) und den zahlreichen Elektrodenflächen (103) durch im wesentliche kovalente Bindung geklebt ist, und dadurch, daß
die Höhe einer Basis jedes Leitungsanschlusses größer ist als die Höhe der Schutzeinrichtung, wobei jeder Leitungsanschluß einen Doppelvorsprungs-Aufbau hat, der aus einer Oberseite und einer Basis besteht.

2. Akustische Oberflächenwellen-Vorrichtung nach Anspruch 1, bei der eine Vertiefung in der Schutzeinrichtung (112) in einem Bereich ausgebildet ist, der dem Bereich der Kammelektrode (102) zugewandt ist.

3. Akustische Oberflächenwellen-Vorrichtung nach Anspruch 1, bei der die Schutzeinrichtung (112) aus einem Einkristall besteht, das aus demselben Material gefertigt ist wie das Substrat (101) und/oder mit demselben Schnittwinkel hergestellt wird, wie das Substrat.

4. Akustische Oberflächenwellen-Vorrichtung nach Anspruch 1, bei der eine Isolierschutzschicht (113) auf der Kammelektrode (102) ausgebildet ist.

5. Akustische Oberflächenwellen-Vorrichtung nach Anspruch 4, bei der eine Isolierschutzschicht (113) aus einem anorganischen Material, wie etwa Silizium oder Siliziumoxid besteht.

6. Akustische Oberflächenwellen-Vorrichtung nach Anspruch 4, bei der der Leitungsanschluß (104) aus einer Basis (104b) besteht, die an die Elektrodenfläche (103) geklebt ist, und einem Vorsprung (104a), der auf der Basis (104b) ausgebildet ist, wobei die Höhe der Basis (104b) größer ist als die Höhe der Schutzeinrichtung (112).

7. Akustische Oberflächenwellen-Vorrichtung nach einem der vorhergehenden Ansprüche, bei der die Isolierschicht (114) so ausgebildet ist, daß sie die Kammelektrode (102) in einem Bereich zwischen der Kammelektrode (102) und den zahlreichen Elektrodenflächen (103) umgibt.

8. Akustische Oberflächenwellen-Vorrichtung nach Anspruch 7, bei der die Isolierschicht (114) aus einem anorganischen Material, wie etwa Silizium oder Siliziumoxid besteht.

9. Akustische Oberflächenwellen-Vorrichtung nach Anspruch 7, bei der die Schutzeinrichtung (112) entweder aus Quartz oder Glas besteht.

10. Herstellungsverfahren für eine akustische Oberfiächenweiien-Vorrichtung enthaltend:
Ausbilden einer Kammelektrode (102) auf einem Substrat (101);
Herstellen mehrerer Elektrodenflächen (103) auf diesem Substrat (101);
Ausbilden einer Schutzeinrichtung (112), die einen abgeschlossenen Raum zwischen der Kammelektrode (102) und der Schutzeinrichtung (112) bildet;
Ausbilden einer leitfähigen Haftschicht (105) wenigstens auf den Oberseiten der Leitungsanschlüsse (104);
Festkleben der Leitungsanschlüsse (104) an einem Elektrodenmuster (108), das sich auf einer Packung (107) befindet; und
Füllen des Zwischenraumes zwischen der Packung (107) und dem Substrat (101) mit einem isolierenden Haftmittel (106), derart, daß das isolierende Haftmittel (106) in Kontakt mit den Leitungsanschlüssen (104), dem leitfähigen Haftmittel (105) und der Schutzeinrichtung (112) steht;
**dadurch gekennzeichnet, daß**
die Schutzeinrichtung (112) an das Substrat (102) oder an eine Isolierschicht (114), die zwischen dem Substrat und der Schutzeinrichtung (112) ausgebildet ist, in einem Bereich zwischen der Kammelektrode (102) und den zahlreichen Elektrodenflächen (103) durch im wesentliche kovalente Bindung geklebt ist, und dadurch, daß
die Höhe einer Basis jedes Leitungsanschlusses größer ist als die Höhe der Schutzeinrichtung, wobei jeder Leitungsanschluß einen Doppelvorsprungs-Aufbau hat, der aus einer Oberseite und einer Basis besteht.

11. Herstellungsverfahren für eine akustische Oberflächenwellen-Vorrichtung nach Anspruch 10, enthaltend das Ausbilden einer Isolierschicht (114), die die Kammelektrode (102) in einem Bereich zwischen der Kammelektrode (102) und den zahlreichen Elektrodenflächen (103) umgibt.

12. Herstellungsverfahren für eine akustische Oberflächenwellen-Vorrichtung nach Anspruch 11, **gekennzeichnet durch** einen Vorgang zum Nivellieren der Isolierschicht (114).

13. Herstellungsverfahren für eine akustische Oberflächenwellen-Vorrichtung nach einem der Ansprüche 10 bis 12, enthaltend das Ausbilden einer isolierenden Schutzschicht (113) auf der Kammelektrode (102).

## Revendications

1. Dispositif à onde acoustique de surface comprenant :
un substrat (101),
une électrode en forme de peigne (102) formée sur une surface principale dudit substrat (101),
plusieurs plages d'électrodes (103) disposées sur la périphérie de ladite électrode en forme de peigne (102),
un moyen de protection (112),
des plots conducteurs (104) formés sur les parties supérieures desdites plusieurs plages d'électrodes (103),
une couche adhésive conductrice (105) disposée au moins sur les parties supérieures desdits plots conducteurs (104),
un boîtier (107) collé sur lesdits plots conducteurs (105) par l'intermédiaire dudit adhésif conducteur (105), et
un adhésif isolant (106) remplissant l'espace entre ledit boîtier (107) et ledit substrat (101), de telle sorte que l'adhésif isolant (106) soit en contact avec la couche adhésive conductrice (105), lesdits plots conducteurs (104), et ledit moyen de protection (112),
**caractérisé en ce que**
ledit moyen de protection (112) recouvre ladite électrode en forme de peigne (102) **en ce qu'**il existe un interstice entre ledit moyen de protection (112) et ladite électrode en forme de peigne (102), dans lequel ledit moyen de protection (112) est lié audit substrat (102) ou à une couche isolante (114) prévue entre ledit substrat et ledit moyen de protection (112), par une liaison substantiellement covalente, dans une région entre ladite électrode en forme de peigne (112) et lesdites plusieurs plages d'électrodes (103), et **en ce que**
la hauteur d'une base de chaque plot conducteur est plus élevée que la hauteur du moyen de protection, où chaque plot conducteur possède une structure à double protubérance constituée d'une partie supérieure et d'une base.

2. Dispositif à onde acoustique de surface selon la revendication 1, dans lequel une indentation est prévue dans ledit moyen de protection (112) au niveau d'une région en regard de ladite région d'électrode en forme de peigne (102).

3. Dispositif à onde acoustique de surface selon la revendication 1, dans lequel ledit moyen de protection (112) est constitué d'un unique cristal fait du même matériau que celui dudit substrat (101) et/ou fait avec le même angle de coupe que ledit substrat.

4. Dispositif à onde acoustique de surface selon la revendication 1, dans lequel une couche de protection isolante (113) est formée sur ladite électrode en forme de peigne (102).

5. Dispositif à onde acoustique de surface selon la revendication 4, dans lequel une couche de protection isolante (113) est constituée d'un matériau inorganique constitué soit de silicium, soit d'oxyde de silicium.

6. Dispositif à onde acoustique de surface selon la revendication 1, dans lequel ledit plot conducteur (104) est constitué d'une base (104b) liée à ladite plage d'électrodes (103) et d'une protubérance (104a) formée sur ladite base (104b), dans lequel la hauteur de ladite base (104b) est supérieure à la hauteur dudit moyen de protection (112).

7. Dispositif à onde acoustique de surface selon l'une quelconque des revendications précédentes, dans lequel ladite couche isolante (114) est formée pour entourer ladite électrode en forme de peigne (102) au niveau d'une région entre ladite électrode en forme de peigne (102) et lesdites plusieurs plages d'électrodes (103).

8. Dispositif à onde acoustique de surface selon la revendication 7, dans lequel ladite couche isolante (114) est faite d'un matériau inorganique constitué soit de silicium, soit d'oxyde de silicium.

9. Dispositif à onde acoustique de surface selon la revendication 7, dans lequel ledit moyen de protection (112) est fait soit de quartz, soit de verre.

10. Procédé de fabrication d'un dispositif à onde acoustique de surface comprenant :
un procédé pour former une électrode en forme de peigne (102) sur un substrat (101),
un procédé pour former plusieurs plages d'électrodes (103) sur ledit substrat (101),
un procédé destiné à prévoir un moyen de protection (112), destiné à former un espace obturé entre ladite électrode en forme de peigne (102) et ledit moyen de protection (112),
un procédé pour former des plots conducteurs (104) sur lesdites plusieurs plages d'électrodes (103),
un procédé pour former une couche adhésive conductrice (105) au moins sur les parties supérieures desdits plots conducteurs (104),
un procédé pour coller lesdits plots conducteurs (104) sur un motif d'électrode (108) disposé sur un boîtier (107), et
un procédé pour remplir l'espace entre ledit boîtier (107) et ledit substrat (101) avec un adhésif isolant (106) de telle sorte que ledit adhésif isolant (106) soit en contact avec lesdits plots conducteurs (104), ledit adhésif conducteur (105) et ledit moyen de protection (112),
**caractérisé en ce que**
ledit moyen de protection (112) est lié audit substrat (102) ou à une couche isolant (114) prévue entre ledit substrat (102) et ledit moyen de protection (112) par une liaison substantiellement covalente, dans une région entre ladite électrode en forme de peigne (102) et lesdites plusieurs plages d'électrodes (103), et **en ce que**
la hauteur d'une base de chaque plot conducteur est supérieure à la hauteur du moyen de protection, où chaque plot conducteur possède une structure à double protubérance constituée d'une partie supérieure et d'une base.

11. Procédé de fabrication d'un dispositif à onde acoustique de surface selon la revendication 10, comprenant un procédé pour former une couche isolante (114) entourant ladite électrode en forme de peigne (102) dans la région entre ladite électrode en forme de peigne (102) et lesdites plusieurs plages d'électrodes (103).

12. Procédé de fabrication d'un dispositif à onde acoustique de surface selon la revendication 11,
**caractérisé par**
un procédé pour mettre à niveau la surface de ladite couche isolante (114).

13. Procédé de fabrication d'un dispositif à onde acoustique de surface conforme à l'une quelconque des revendications 10 à 12, comprenant un procédé pour former une couche de protection isolante (113) sur ladite électrode en forme de peigne (102).
